(19) Europäisches Patentamt
European Patent Office
Office européen des brevets

(11) **EP 4 760 482 A1**

(12) **EUROPEAN PATENT APPLICATION**

(43) Date of publication:
**17.06.2026 Bulletin 2026/25**

(21) Application number: **25221601.5**

(22) Date of filing: **08.12.2025**

(51) International Patent Classification (IPC):
**G06F 7/501** (2006.01)  **H03K 19/0948** (2006.01)

(52) Cooperative Patent Classification (CPC):
**G06F 7/5016; H03K 19/0948**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **12.12.2024 IN 202441098442**

(71) Applicant: **Samsung Electronics Co., Ltd.**
**Suwon-si, Gyeonggi-do 16677 (KR)**

(72) Inventors:
• **GOYAL, Mitesh**
**560048 Bengaluru (IN)**
• **AGARWAL, Somya**
**560048 Bengaluru (IN)**
• **DHANAWADE, Mayuresh**
**560048 Bengaluru (IN)**
• **GHOSH, Abhishek**
**560048 Bengaluru (IN)**
• **SINGH, Akash**
**560048 Bengaluru (IN)**

(74) Representative: **Marks & Clerk LLP**
**15 Fetter Lane**
**London EC4A 1BW (GB)**

(54) **ULTRA-HIGH SPEED FULL ADDER (FA) AND CARRY GENERATOR CIRCUIT**

(57)    A Full Adder (FA) circuit may include a Sum Generation (SG) circuit configured to: generate at least one of an XNOR signal or an XOR signal using at least one of a first NOR signal, an AND signal, a NAND signal, and an OR signal; and generate an output SUM signal using the generated at least one of the XN signal and the X signal. The FA circuit may further include a Carry Output Generation (COG) circuit connected to the SG circuit to generate a CO signal using the first NOR signal, the AND signal, the NAND signal, and/or the OR signal.

FIG. 6

EP 4 760 482 A1

**Description**

Technical Field

Embodiments disclosed herein relate to Full Adder (FA) circuits, and more particularly to an FA circuit with an ultra-high speed performance.

Discussion of Related Art

Generally, Full Adders (FA) and carry generators are combinational logic cells that may be used for Artificial Intelligence (AI)/ Machine Language (ML) and high performance computing applications. A one bit Full Adder is an adder circuit that adds three bits, i.e., two one bit operands and a carry in bit, to generate a sum bit and a carry out (CO) bit. A Full Adder (FA) logic can be implemented using multiple transistors, inverters, and logical gates such as pass gates, AND gates, OR gates, XOR gates, and so on.

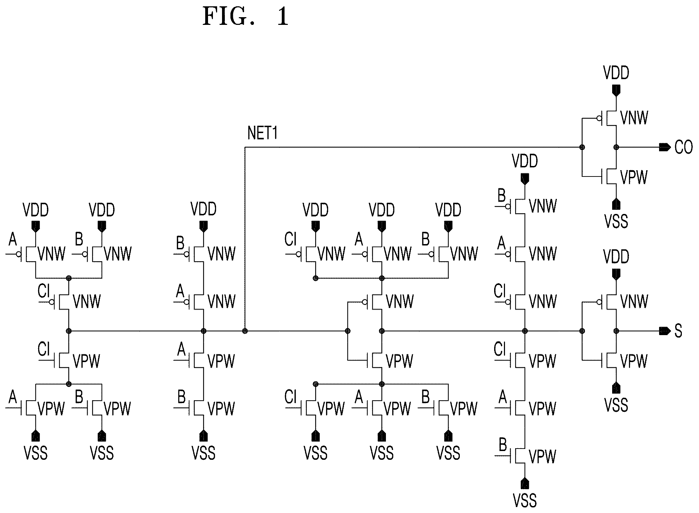

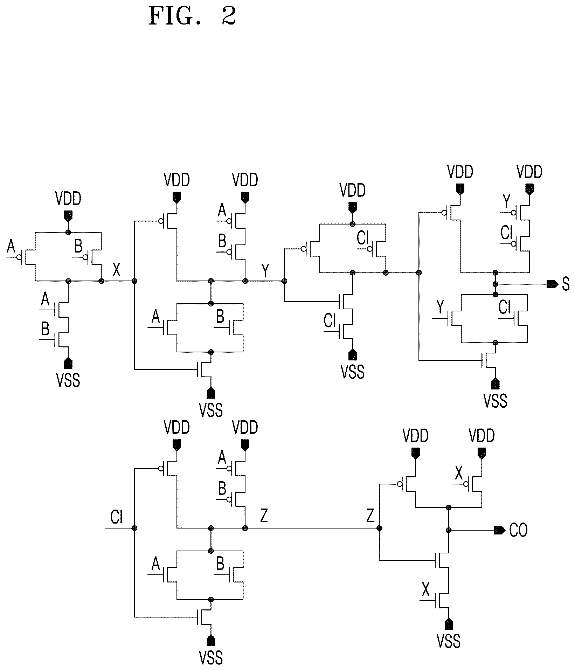

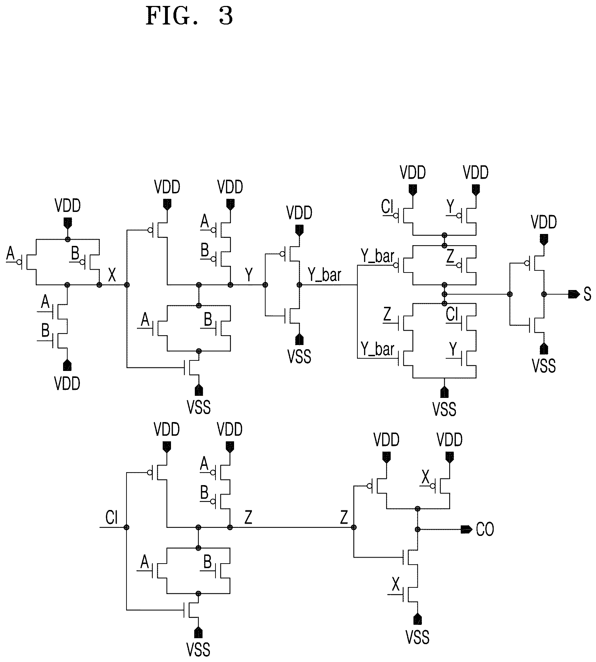

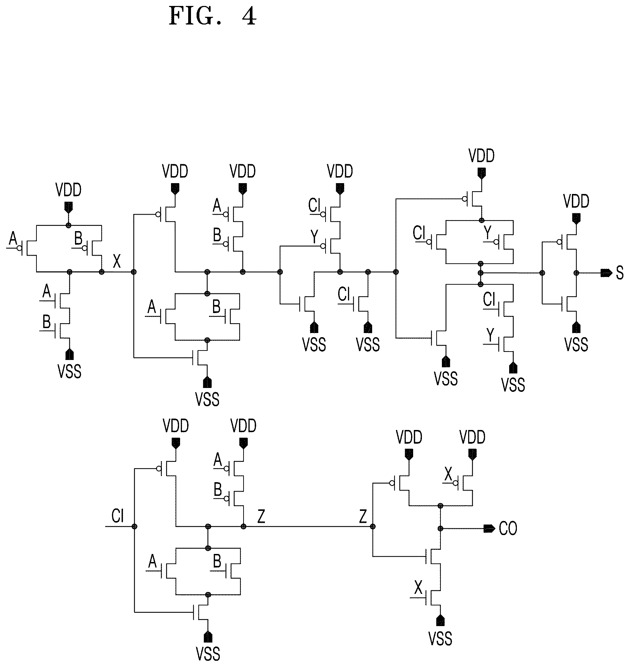

FIG. 1 depicts a conventional FA circuit used in a standard cell library which uses 28 transistors. FIGS. 2 and 3 depict a conventional FA circuit used in a basic standard cell library which uses 30 and 32 transistors, respectively. FIG. 4 depicts a conventional FA circuit used in the basic standard cell library which uses 32 transistors arranged differently than in FIG. 3.

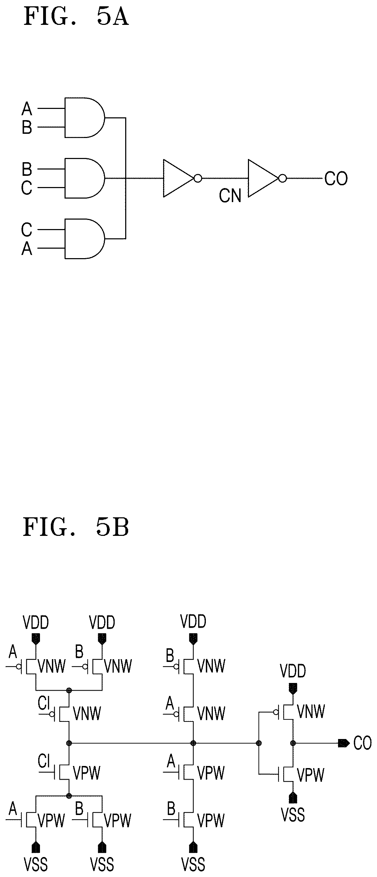

A Carry Out (CO) is a "majority function" of a first single binary digit (bit) "A", a second single binary digit "B", and CarryIn (CI). (With a majority function, the value of the function equals the value of the majority of the inputs. The output Boolean function is 0 when 2 more of A, B and CI are 0; and 1 otherwise.) A Sum (S) is an XOR function of A, B, and CarryIn (CI). FIG. 5A depicts a conventional logic gate diagram of a Carry Out generator circuit. FIG. 5B depicts a Carry Out generator core circuit of the logic gate diagram depicted in FIG. 5A.

Conventional FA circuits may be designed for low power delay products and lowest possible speed applications. For high speed applications, low latency CarryIn to carryout paths are needed for high timing constraint designs. In existing circuits, an adder CarryIn pin is connected to six transistors while an output stage is connected to four transistors. Further, each input of the FA circuit is connected in a cascaded manner. Due to heavy loading of the transistors, the speed of operation and internal propagation delay of the design can degrade. In addition, conventional designs may not be optimized for at least two input states, e.g., A=0, B=1 and A=1, B=0 states. Other known FA circuits are pass gate based circuits which have low reliability to noise and signal deformities due to coupling. In still other known FA circuits, multiple stages are used in cascaded manner which can degrade the circuit performance and are therefore not useful for high speed applications.

Further, existing FA circuits use a truth table based adder implementation which in a CMOS process uses 28 transistors. XOR implementation in the FA circuits uses transmission gates; however, the circuits have glitches due to internal cell delay mismatches.

Thus, existing FA circuits have high input capacitance on relevant nets. Further, at the input of slow rising/falling signals, stacked (cascaded) transistors degrade internal slews and delays.

Hence, there is a need in the art for solutions which will overcome the above-mentioned drawback(s), among others.

SUMMARY

Embodiments herein provide a Full Adder (FA) circuit. The FA circuit comprises a Sum Generation (SG) circuit, and a Carry Output Generation (COG) circuit. The SG circuit is configured to generate at least one of an XNOR (XN) signal, and an XOR (X) signal using at least one of a first NOR signal, an AND signal, a NAND signal, and a OR signal. The SG circuit is further configured to generate an output SUM signal using the generated at least one of the XN signal and the X signal. The COG circuit is connected to the SG circuit and configured to generate a CO signal using at least one of the first NOR signal, the AND signal, the NAND signal, or the OR signal.

The FA circuit may be configured to calculate the sum of a first signal and a second signal. The first signal and the second signal may be respective bits (e.g. signal binary digits) (e.g. from within two binary numbers being added). The at least one of the first NOR signal, the AND signal, the NAND signal and the OR signal may be function(s) of the first input signal and the second input signal. The output SUM signal may represent a sum of the first input signal and the second input signal where carry overs are ignored (e.g. not including carry overs) (e.g. addition without carrying). The CO signal may represent the carry over (e.g. the carry) from the sum of the first input signal and the second input signal.

The FA circuit may be configured to receive a third input signal. The third input signal may be a carry in signal (e.g. representing a carry over from a preceding addition operation, such as an addition of a previous pair of less-significant bits). The FA circuit may be configured to calculate the sum of the first, second and third input signals. The output SUM signal may represent a sum of the first input signal, the second input signal and the third input signal where carry overs are ignored (e.g. not including carry overs) (e.g. addition without carrying). The CO signal may represent the carry over (e.g. the carry) from the sum of the first input signal, the second input signal and the third input signal.

The FA circuit may implement logic gates utilising complimentary metal-oxide-semiconductor (CMOS) transistors.

At least some of the above and other features of the invention are set out in the claims.

BRIEF DESCRIPTION OF THE FIGURES

Embodiments herein are illustrated in the accompanying drawings, throughout which like reference letters indicate corresponding parts in the various figures. The embodiments herein will be better understood from the following description with reference to the following illustrative drawings. Embodiments herein are illustrated by way of examples in the accompanying drawings, and in which:

FIG. 1 depicts a conventional FA circuit used in a standard cell library which uses 28 transistors, according to existing arts;
FIG. 2 depicts a conventional FA circuit used in a basic standard cell library which uses 30 transistors, according to existing arts;
FIG. 3 depicts a conventional FA circuit used in the basic standard cell library which uses 32 transistors, according to existing arts;
FIG. 4 depicts a conventional FA circuit used in the basic standard cell library which uses 32 transistors, according to existing arts;
FIG. 5A depicts a conventional logic gate diagram of a Carry Out generator circuit, according to existing arts;
FIG. 5B depicts a Carry Out generator core circuit of the logic gate diagram depicted in FIG. 5A, according to existing arts;
FIG. 6 depicts a block diagram illustrating a Full Adder (FA) circuit, according to embodiments as disclosed herein;
FIG. 7 depicts a core circuit of the FA circuit, according to embodiments as disclosed herein;
FIG. 8 depicts an alternative core circuit of the FA circuit, according to embodiments as disclosed herein;
FIG. 9 depicts an alternative core circuit of the FA circuit, according to embodiments as disclosed herein;
FIG. 10 depicts an alternative core circuit of the FA circuit, according to embodiments as disclosed herein;
FIG. 11 depicts an alternative core circuit of the FA circuit, according to embodiments as disclosed herein;
FIG. 12 depicts an alternative core circuit of the FA circuit, according to embodiments as disclosed herein;
FIG. 13 depicts an alternative core circuit of the FA circuit, according to embodiments as disclosed herein;
FIG. 14 depicts an alternative core circuit of the FA circuit, according to embodiments as disclosed herein;
FIG. 15 depicts an alternative core circuit of the FA circuit, according to embodiments as disclosed herein; and
FIG. 16 depicts a logic gate diagram of the COG circuit, according to embodiments as disclosed herein.

DETAILED DESCRIPTION

The embodiments herein and the various features and advantageous details thereof are explained more fully with reference to the non-limiting embodiments that are illustrated in the accompanying drawings and detailed in the following description. Descriptions of well-known components and processing techniques are omitted so as to not unnecessarily obscure the embodiments herein. The examples used herein are intended merely to facilitate an understanding of ways in which the embodiments herein may be practiced and to further enable those of skill in the art to practice the embodiments herein. Accordingly, the examples should not be construed as limiting the scope of the embodiments herein.

For the purposes of interpreting this specification, the definitions (as defined herein) will apply and whenever appropriate the terms used in singular will also include the plural and vice versa. It is to be understood that the terminology used herein is for the purposes of describing particular embodiments only and is not intended to be limiting. The terms "comprising", "having" and "including" are to be construed as open-ended terms unless otherwise noted. As used herein, each of such phrases as "A or B", "at least one of A and B", "at least one of A or B", "A, B, or C", "at least one of A, B, and C", and "at least one of A, B, or C", may include any one of possible combinations of the items enumerated together in a corresponding one of the phrases.

The words/phrases "exemplary", "example", "illustration", "in an instance", "and the like", "and so on", "etc.", "etcetera", "e.g.," , "i.e.," are merely used herein to mean "serving as an example, instance, or illustration." Any embodiment or implementation of the present subject matter described herein using such words/phrases is not necessarily to be construed as preferred or advantageous over other embodiments.

Embodiments herein may be described and illustrated in terms of blocks which carry out a described function or functions. Circuits herein may, for example, be embodied in one or more semiconductor chips, or on substrate supports such as printed circuit boards and the like. Each block of the embodiments may be physically separated into two or more interacting and discrete blocks without departing from the scope of the disclosure. Likewise, the blocks of the embodiments may be physically combined into more complex blocks without departing from the scope of the disclosure.

It should be noted that elements in the drawings are illustrated for the purposes of this description and ease of understanding. For example, the flowcharts/sequence diagrams illustrate the method in terms of the steps required for understanding of aspects of the embodiments as disclosed herein. Furthermore, in terms of the construction of the device, one or more components of the device may have been represented in the drawings by conventional symbols, and the drawings may show only those specific details that are pertinent to understanding the present embodiments so as not to obscure the drawings with details that will be readily apparent to those of ordinary skill in the art having the benefit of the description herein. Furthermore, in terms of the system, one or more components/modules which comprise the system may have been represented in the drawings by conventional symbols, and the drawings may show only those specific details that are pertinent to understanding the present embodiments so as not to obscure the drawings with details that will be readily apparent to those of ordinary skill in the art having the benefit of the description herein.

The accompanying drawings are used to help easily understand various technical features and it should be understood that the embodiments presented herein are not limited by the accompanying drawings. As such, the present disclosure should be construed to extend to any modifications, equivalents, and substitutes in addition to those which are particularly set out in the accompanying drawings and the corresponding description. Usage of words such as first, second, third etc., to describe components/elements/steps is for the purposes of this description and should not be construed as sequential ordering/placement/occurrence unless specified otherwise.

Various embodiments of the inventive concept relate to ultra-high speed Full Adder (FA) circuits and methods for high speed circuit applications such as Arcwise® (an AI data analytics tool) and pin specific latency optimization. The FA circuits according to embodiments may be implemented with fewer stages and transistors as compared to conventional designs, while providing comparable performance at high speed data input. The FA circuits may be configured with Complementary Metal-Oxide-Semiconductor (CMOS) base static logic circuit to make optimal use of the transistors and limit the net and transistor input capacitance.

In embodiments described below, FA circuits are advantageously configured with four transistors on an input stage and two transistors on an output stage (total two stages). The FA circuits may beneficially have minimal input stage capacitance and corresponding next stages with minimal capacitance resulting in a fast Carry In (CI) to Carry-Out (CO) path.

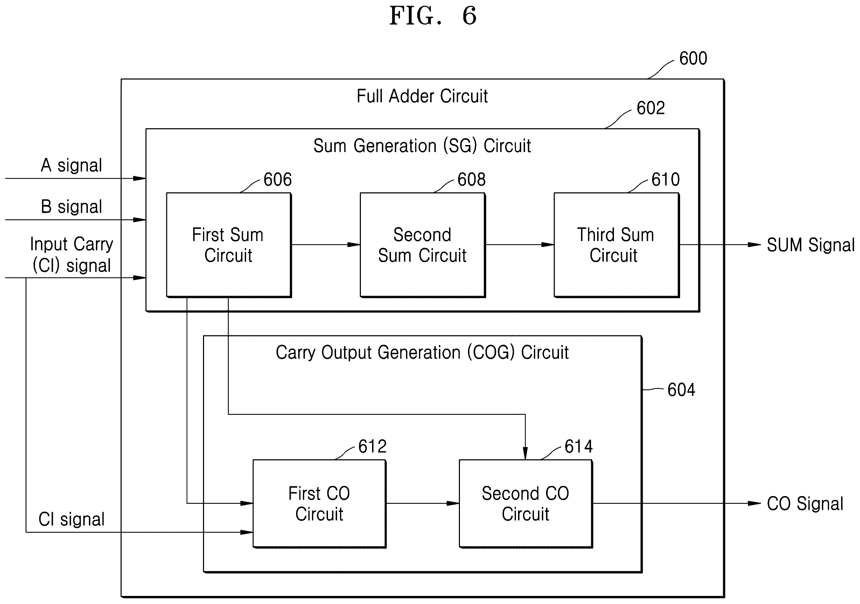

Accordingly, embodiments described herein provide an ultra-high speed Full Adder (FA) circuit with limited transistor count for high speed computing applications. Referring now to the drawings, and more particularly to FIGS. 6 through 16, where similar reference characters denote corresponding features consistently throughout the figures, there are shown embodiments.

It is noted first that herein, either of the terms AnandB or ABbar may be used interchangeably to represent a NAND result of an input signal A and an input signal B. Similarly, either term AnorB or AorBbar may be used interchangeably to represent a NOR result of an input signal A and an input signal B. The same terminology may apply to input signals of different labels.

FIG. 6 depicts a block diagram illustrating a Full Adder (FA) circuit 600 according to an exemplary embodiment of the inventive concept. The FA circuit 600 may include a Sum Generation (SG) circuit 602 and a Carry Output Generation (COG) circuit 604.

The SG circuit 602 may be configured to generate at least one of an XNOR (XN) signal or an XOR (X) signal using one or more of a first NOR signal, an AND signal, a NAND signal, or an OR signal. The SG circuit 602 may be configured to generate an output SUM signal ("S") using the XN signal and/or the X signal. The SG circuit 602 may further include a first sum circuit 606, a second sum circuit 608, and a third sum circuit 610.

The first sum circuit 606 may include at least one of a first NOR gate, a first NAND gate, a first inverter, a first "AOI" circuit ("AND-OR-Inverter", including an AND gate, OR gate, and an Inverter gate), a second AOI circuit, a first OR-AND-Inverter (OAI) circuit (including an OR gate, an AND gate, and an Inverter gate), and a second OAI circuit. The first sum circuit 606 may be configured to receive a first input signal (for example, A input signal), and a second input signal (for example, B input signal), and generate at least one of the first NOR signal, the AND signal, the NAND signal, or the OR signal.

The second sum circuit 608 may include at least one of a second NOR gate, a second NAND gate, or a second inverter. The second sum circuit 608 is connected to the first sum circuit 606 to generate at least one of the XN signal, and the X signal using one or more of the first NOR signal, the AND signal, the NAND signal, or the OR signal.

The third sum circuit 610 may include at least one of a third inverter, a tristate inverter, a transmission gate, at least one pass gate pair, or a fourth inverter. The third sum circuit 610 is connected to the second sum circuit 608 to generate the output SUM signal ("S") using a third input signal (e.g., an input carry ("CI") signal) and the XN signal and/or the X signal.

The COG circuit 604 may be connected to the SG circuit 602 to generate a Carry Output (CO) signal (interchangeably, "Carry Out (CO) signal") using at least one of the first NOR signal, the AND signal, the NAND signal, or the OR signal. The COG circuit 604 further includes a first Carry Output (CO) circuit 612, and a second CO circuit 614.

The SG circuit 602 (e.g. the first sum circuit 606) may generate and send to the first CO circuit 612 at least one of the AND signal or the OR signal. The SG circuit 602 may generate and send to the second CO circuit 614 at least one of the first NOR signal or the NAND signal.

The first CO circuit 612 includes at least one of a third NOR gate or a third NAND gate. The first CO circuit 612 is connected to the first sum circuit 606 to generate a third NOR signal using the third input signal (e.g., the CI signal) and at least one of the AND signal or the OR signal.

The second CO circuit 614 includes at least one of a fourth NOR gate or a fourth NAND gate. The second CO circuit 614 is connected to the first CO circuit 612 and the first sum circuit 606 to generate the CO signal using the third NOR signal and at least one of the first NOR signal or the NAND signal.

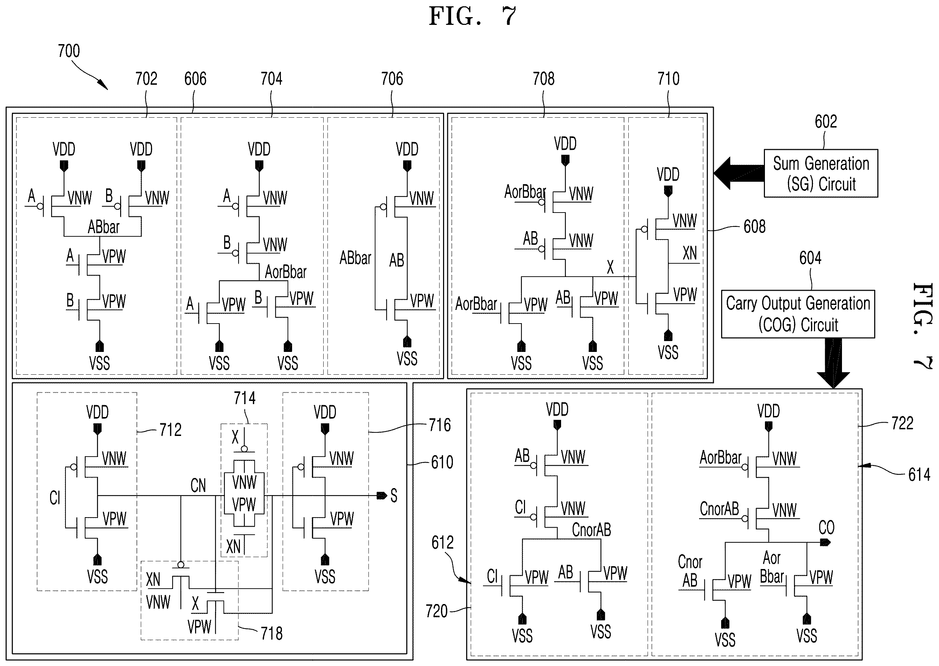

FIG. 7 depicts a core circuit 700, which is an example of the Full Adder (FA) circuit 600. The core circuit 700 may include the SG circuit 602 for generating the output SUM signal ("S"), and the COG circuit 604 for generating the CO signal. The SG circuit 602 may include components of the first sum circuit 606, the second sum circuit 608, and the third sum circuit 610. The SG circuit 602 may include the first NAND gate 702, the first NOR gate 704, the first inverter 706, the second NOR gate 708, the second inverter 710, the third inverter 712, the transmission gate 714, two pass gates 718, and the fourth inverter 716. The COG circuit 604 may include components of the first CO circuit 612, and the second CO circuit 614. The first CO circuit 612 may include the third NOR gate 720, and the second CO circuit 614 may include the fourth NOR gate 722. It is noted here that in FIG. 7 as well as other figures herein, VDD may be a positive power supply voltage, VSS may be a negative or ground power supply voltage, VPW may be a p-well body bias voltage, and VNW may ben n-well body bias voltage.

In the embodiment of FIG. 7, the first sum circuit 606 is configured to receive the A input signal and the B input signal and generate a first AB signal as the AND signal and an AorBbar signal as the first NOR signal. The second sum circuit 608 is configured to receive the first AB signal and the AorBbar signal and generate the XN (e.g. the XNOR) signal. The third sum circuit 610 is configured to receive the CI signal, the X signal and the XN signal and generate the SUM signal. The first CO circuit 612 is configured to receive the first AB signal and the CI signal and output a first CO circuit output signal (e.g. a CnorAB signal) and the second CO circuit 614 is configured to receive the first CO circuit output signal and the AorBbar signal and generate the CO signal.

The first NOR gate 704 of the first sum circuit 606 performs a NOR function of the A input signal and the B input signal, and generates the AorBbar signal as the first NOR signal (representing the NOR result of the inputs A and B). The first NAND gate 702 followed by the first inverter 706 of the first sum circuit 606 performs an AND function of the A input signal and the B input signal, and generates the first AB signal as the AND signal. That is, the first NAND gate 702 may be configured to perform a NAND function of the A input signal and the B input signal, to generate an ABbar signal as the NAND signal. The inverter 706 may be configured to invert the NAND signal to generate the first AB signal as the AND signal. The second NOR gate 708 of the second sum circuit 608 performs a NOR function of the first AB signal and the AorBbar signal, and based on these signals, generates the X signal (e.g. the XOR signal). The X signal is converted to the XN signal (e.g. the XNOR signal) using the second inverter 710 of the second sum circuit 608.

The third inverter 712 of the third sum circuit 610 inverts the CI input signal into an inverted CI signal, hereafter a "CN" signal, and outputs the CN signal to the transmission gate 714 and two pass gates 718 of the third sum circuit 610. The transmission gate 714 is controlled by the XN signal and the X signal, and the two pass gates 718 are controlled by the CN signal with the X signal and the XN signal as inputs to generate an output. The output received from the two pass gates 718 and the transmission gate 714 is inverted using the fourth inverter 716 to obtain the output SUM signal.

The third NOR gate 720 of the first CO circuit 612 uses the first AB signal (AND signal representing the AND result of the A and B inputs) from the first sum circuit 606, and the CI input signal to generate the CnorAB signal (e.g. the first CO circuit output signal) as the third NOR signal (representing the NOR result of the CI input signal and first AB signal as inputs). The CnorAB signal, and the AorBbar signal (first NOR signal) from the first sum circuit 606 are fed to the fourth NOR gate 722 of the second CO circuit 614 to generate the CO signal.

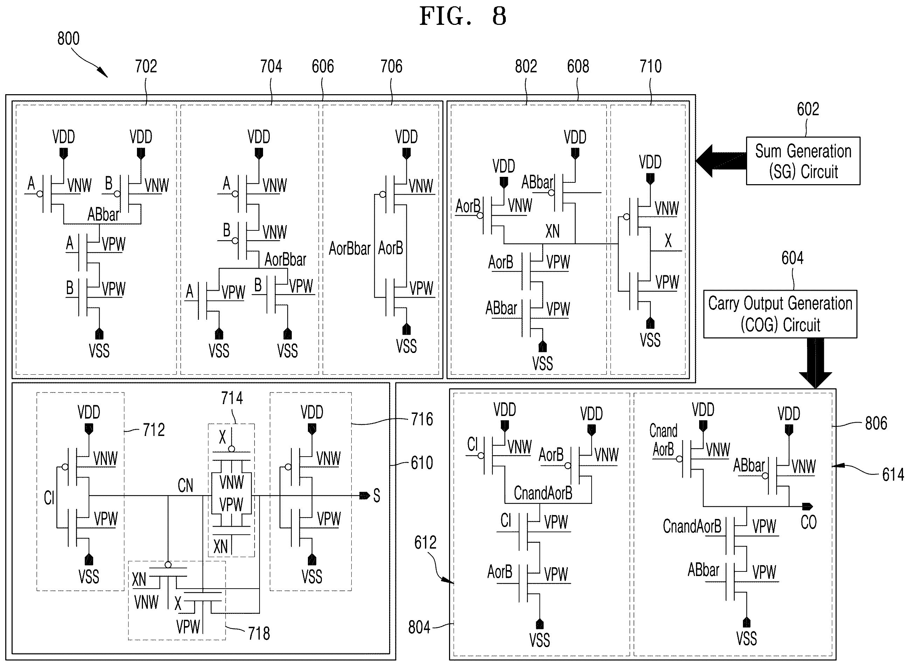

FIG. 8 depicts an alternative core circuit, 800, which is another example of the FA circuit 600. The core circuit 800 may include the SG circuit 602 for generating the output SUM signal, and the COG circuit 604 for generating the CO signal. The SG circuit 602 may include the first NAND gate 702, the first NOR gate 704, the first inverter 706, the second NAND gate 802, the second inverter 710, the third inverter 712, the transmission gate 714, two pass gates 718, and the fourth inverter 716. The COG circuit 604 may include components of the first CO circuit 612, and the second CO circuit 614. In this embodiment herein, the first CO circuit 612 may include the third NAND gate 804, and the second CO circuit 614 may include the fourth NAND gate 806.

In the embodiment of FIG. 8, the first sum circuit 606 is configured to receive the A input signal and the B input signal and generate an ABbar signal as the NAND signal and an AorB signal as the OR signal. The second sum circuit 608 is configured to receive the ABbar signal and the AorB signal and generate the X signal (e.g. XOR signal) and the XN signal (e.g. the XNOR signal). The third sum circuit 610 is configured to receive the CI signal, the X signal and the XN signal and generate the SUM signal. The first CO circuit 612 is configured to receive the AorB signal and the CI signal and output a first CO circuit output signal (e.g. a CnandAorB signal) and the second CO circuit 614 is configured to receive the first CO circuit output signal and the ABbar signal and generate the CO signal.

The first NAND gate 702 of the first sum circuit 606 performs a NAND function of the A input signal and the B input signal, and thereby generates an ABbar signal as the NAND signal. The first NOR gate 704 followed by the first inverter 706 of the first sum circuit 606 performs an OR function of the A input signal and the B input signal, and thereby generates an AorB signal as the OR signal. That is, the first NOR gate 704 may be configured to perform a NOR function of the A input signal and the B input signal to generate an AorBbar signal. The first inverter 706 may be configured to invert the AorBbar signal to generate the AorB signal. The second NAND gate 802 of the second sum circuit 608 performs a NAND function of the AorB signal and the ABbar signal, and thereby generates the XN signal. The XN signal is converted to the X signal using the second inverter 710 of the second sum circuit 608.

The third inverter 712 of the third sum circuit 610 inverts the CI input signal into a CN signal, and outputs the CN signal to the transmission gate 714 and two pass gates 718 of the third sum circuit 610. The transmission gate 714 is controlled by the XN signal and the X signal, and the two pass gates 718 are controlled by the CN signal with the X signal and the XN signal as inputs to generate an output. The output received from the two pass gates 718 and the transmission gate 714 is inverted using the fourth inverter 716 to obtain the output SUM signal.

The third NAND gate 804 of the first CO circuit 612 uses the AorB signal (OR signal representing the OR result of the A input signal and the B input signal) from the first sum circuit 606, and the CI input signal to generate a CnandAorB signal (e.g. a first CO circuit output signal) (representing the NAND result of the CI input signal and the AorB signal). The CnandAorB signal, and the ABbar signal (NAND signal representing the NAND result of the A input signal and the B input signal) from the first sum circuit 606 are fed to the fourth NAND gate 806 of the second CO circuit 614 to generate the CO signal.

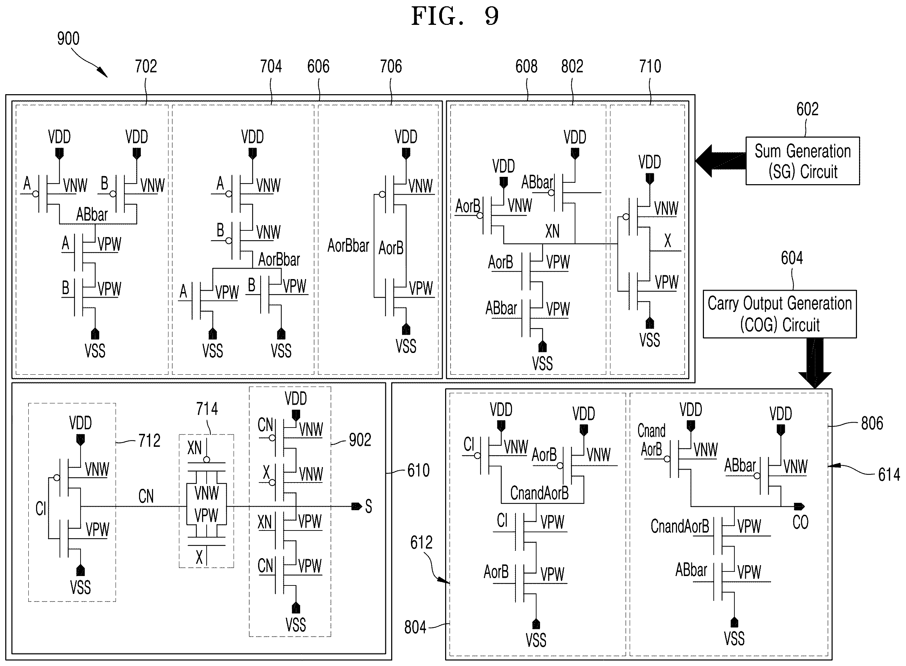

FIG. 9 depicts another example core circuit, 900, of the FA circuit 600. The core circuit 900 may include the SG circuit 602 for generating the output SUM signal, and the COG circuit 604 for generating the CO signal. The SG circuit 602 may include the first NAND gate 702, the first NOR gate 704, the first inverter 706, the second NAND gate 802, the second inverter 710, the third inverter 712, the transmission gate 714, and the tristate inverter 902. The COG circuit 604 may include components of the first CO circuit 612, and the second CO circuit 614. In this embodiment, the first CO circuit 612 may include the third NAND gate 804, and the second CO circuit 614 may include the fourth NAND gate 806.

The embodiment of FIG. 9 is similar to the embodiment of FIG. 8, with an altered third sum circuit 610. Unlike the embodiment of FIG. 8, the third sum circuit 610 of FIG. 9 includes the third inverter 712, the transmission gate 714, and the tristate inverter 902.

The first NAND gate 702 of the first sum circuit 606 performs a NAND function of the A input signal and the B input signal, and generates an ABbar signal as the NAND signal. The first NOR gate 704 followed by the first inverter 706 of the first sum circuit 606 performs an OR function of the A input signal and the B input signal, and generates an AorB signal as the OR signal. That is, the first NOR gate 704 may be configured to perform a NOR function of the A input signal and the B input signal to generate an AorBbar signal. The first inverter 706 may be configured to invert the AorBbar signal to generate the AorB signal. The second NAND gate 802 of the second sum circuit 608 performs a NAND function of the AorB signal and the ABbar signal, and generates the XN signal. The XN signal is converted to the X signal using the second inverter 710 of the second sum circuit 608.

The third inverter 712 of the third sum circuit 610 inverts the CI input signal into the CN signal. The transmission gate 714 and the tristate inverter 902 are fed with the CN signal and controlled by the X signal and the XN signal of the second sum circuit 608. Outputs of the transmission gate 714 and the tristate inverter 902 are connected to generate the output SUM ("S") signal.

The third NAND gate 804 of the first CO circuit 612 uses the AorB signal (OR signal) from the first sum circuit 606, and the CI input signal to generate a CnandAorB signal. The CnandAorB signal, and the ABbar signal (NAND signal) from the first sum circuit 606 are fed to the fourth NAND gate 806 of the second CO circuit 614 to generate the CO signal.

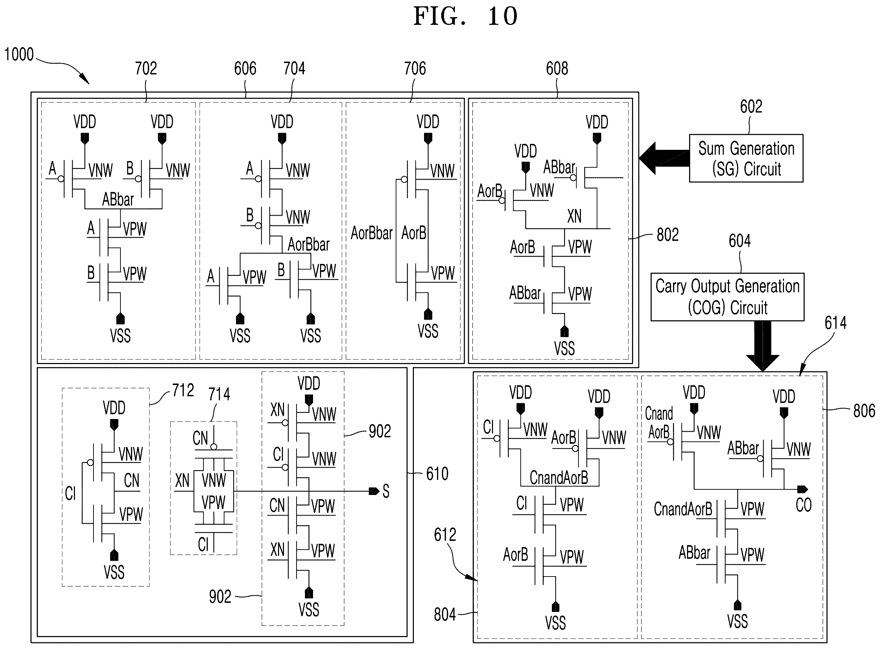

FIG. 10 depicts an alternative example of a core circuit, 1000, of the FA circuit 600. The core circuit 1000 may include the SG circuit 602 for generating the output SUM signal, and the COG circuit 604 for generating the CO signal. The SG circuit 602 may include the first NAND gate 702, the first NOR gate 704, the first inverter 706, the second NAND gate 802, the third inverter 712, the transmission gate 714, and the tristate inverter 902. The COG circuit 604 may include components of the first CO circuit 612, and the second CO circuit 614. In this embodiment, the first CO circuit 612 may include the third NAND gate 804, and the second CO circuit 614 may include the fourth NAND gate 806.

The embodiment of FIG. 10 is similar to the embodiment of FIG. 9, with an altered second sum circuit 608 and an altered third sum circuit 610. Unlike the embodiment of FIG. 8, the second sum circuit 608 only generates the XN signal. The third sum circuit 610 is configured to receive the CI signal and the XN signal and determine the SUM signal.

The first NAND gate 702 of the first sum circuit 606 performs a NAND function of the A input signal and the B input signal, and generates an ABbar signal as the NAND signal. The first NOR gate 704 followed by the first inverter 706 of the first sum circuit 606 performs an OR function of the A input signal and the B input signal, and generates an AorB signal as the OR signal. That is, the first NOR gate 704 may be configured to perform a NOR function of the A input signal and the B input signal to generate an AorBbar signal. The first inverter 706 may be configured to invert the AorBbar signal to generate the AorB signal. The second NAND gate 802 of the second sum circuit 608 performs a NAND function of the AorB signal and the ABbar signal, and generates the XN signal.

The third inverter 712 of the third sum circuit 610 inverts the CI input signal into the CN signal. The transmission gate 714 and the tristate inverter 902 are fed with the XN signal of the second sum circuit 608, and are controlled by the CI signal and the CN signal. Outputs of the transmission gate 714 and the tristate inverter 902 are connected to generate the output SUM signal.

The third NAND gate 804 of the first CO circuit 612 uses the AorB signal (OR signal) from the first sum circuit 606, and the CI input signal to generate a CnandAorB signal. The CnandAorB signal, and the ABbar signal (NAND signal) from the first sum circuit 606 are fed to the fourth NAND gate 806 of the second CO circuit 614 to generate the CO signal.

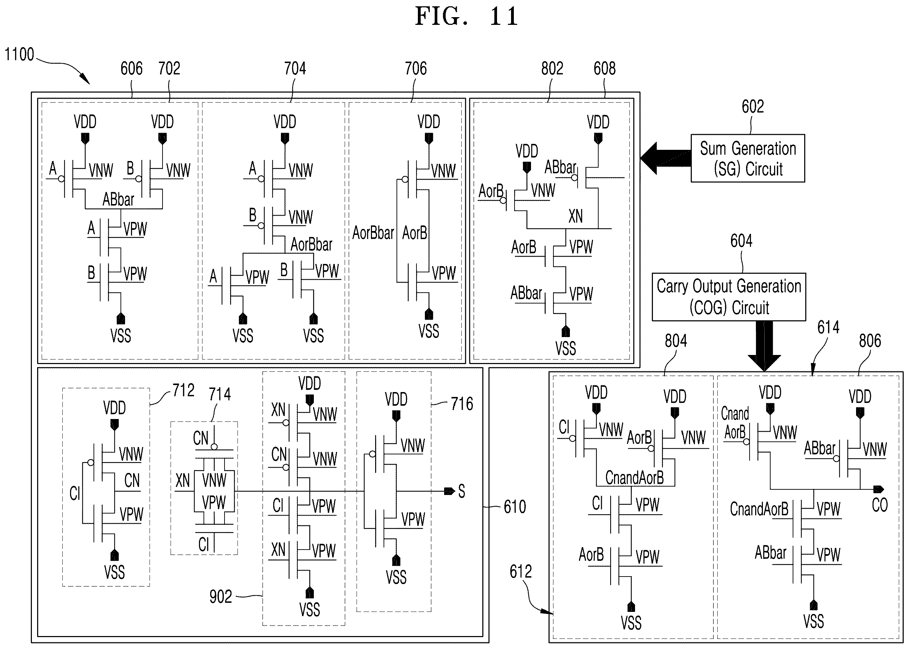

FIG. 11 depicts an alternative example of a core circuit, 1100, of the FA circuit 600. The core circuit 1100 may include the SG circuit 602 for generating the output SUM signal, and the COG circuit 604 for generating the CO signal. The SG circuit 602 may include the first NAND gate 702, the first NOR gate 704, the first inverter 706, the second NAND gate 802, the third inverter 712, the transmission gate 714, the tristate inverter 902, and the fourth inverter 716. The COG circuit 604 may include components of the first CO circuit 612, and the second CO circuit 614. In this embodiment, the first CO circuit 612 may include the third NAND gate 804, and the second CO circuit 614 may include the fourth NAND gate 806.

The first sum circuit 606 and the COG circuit 604 of the embodiment of FIG. 11 are similar to the first sum circuit 606 and the COG circuit 604 of the embodiment of FIG. 8. In the embodiment of FIG. 11, the second sum circuit 608 generates only the XN signal (e.g. does not generate the X signal), which is used by the third sum circuit 610 to generate the SUM signal.

The first NAND gate 702 of the first sum circuit 606 performs a NAND function of the A input signal and the B input signal, and generates an ABbar signal as the NAND signal. The first NOR gate 704 followed by the first inverter 706 of the first sum circuit 606 performs an OR function of the A input signal and the B input signal, and generates an AorB signal as the OR signal. That is, the first NOR gate 704 may be configured to perform a NOR function of the A input signal and the B input signal to generate an AorBbar signal. The first inverter 706 may be configured to invert the AorBbar signal to generate the AorB signal. The second NAND gate 802 of the second sum circuit 608 performs a NAND function of the AorB signal and the ABbar signal, and generates the XN signal.

The third inverter 712 of the third sum circuit 610 inverts the CI input signal into the CN signal. The transmission gate 714 and the tristate inverter 902 are fed with the XN signal of the second sum circuit 608. The transmission gate 714 is controlled by the CI signal and the CN signal. The tristate inverter 902 is controlled by the CI input signal and the CN signal. The tristate inverter 902 is followed by the fourth inverter 716 to generate the output SUM signal.

The third NAND gate 804 of the first CO circuit 612 uses the AorB signal (OR signal) from the first sum circuit 606, and the CI input signal to generate a CnandAorB signal. The CnandAorB signal, and the ABbar signal (NAND signal) from the first sum circuit 606 are fed to the fourth NAND gate 806 of the second CO circuit 614 to generate the CO signal.

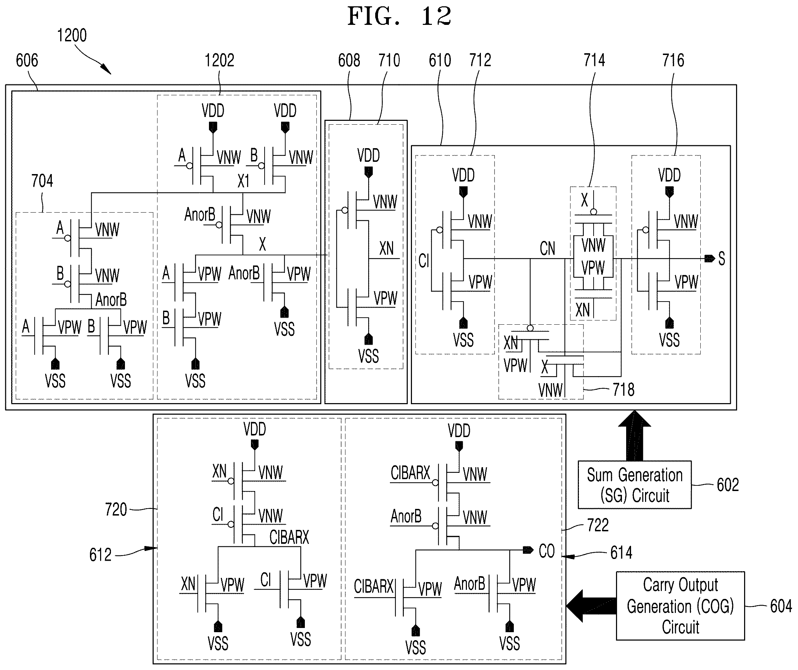

FIG. 12 depicts yet another example core circuit 1200, of the FA circuit 600. The core circuit 1200 may include the SG circuit 602 for generating the output SUM signal, and the COG circuit 604 for generating the CO signal. The SG circuit 602 may include the first AOI circuit 1202, and the first NOR gate 704 of the first sum circuit 606, the second inverter 710 of the second sum circuit 608, the third inverter 712, the transmission gate 714, two pass gates 718, and the fourth inverter 716 of the third sum circuit 610. The COG circuit 604 may include components of the first CO circuit 612, and the second CO circuit 614. In this embodiment, the first CO circuit 612 may include the third NOR gate 720, and the second CO circuit 614 may include the fourth NOR gate 722.

In the embodiment of FIG. 12, the first sum circuit 606 is configured to receive the A input signal and the B input signal and generate the X signal and an AnorB signal. The second sum circuit 608 is configured to receive the X signal and generate the XN signal. The third sum circuit 610 is configured to receive the CI signal, the X signal and the XN signal and generate the SUM signal. The first CO circuit 612 is configured to receive the CI signal and the XN signal and output a first CO circuit output signal (e.g. a CIBARX signal) and the second CO circuit 614 is configured to receive the first CO circuit output signal and the AnorB signal and generate the CO signal.

The first AOI circuit 1202 may include an AND gate, an OR gate, and an inverter gate to perform an AND function of the A input signal and the B input signal, followed by an OR function with an AnorB signal representing a NOR result of the A input signal and the B input signal, and inverting the output of the OR gate to generate the X signal. The first NOR gate 704 is connected to the first AOI circuit 1202 to send the AnorB signal which is generated from the A input signal and the B input signal. The X signal is converted to the XN signal using the second inverter 710 of the second sum circuit 608.

The third inverter 712 of the third sum circuit 610 inverts the CI input signal into a CN signal, and outputs the CN signal to the transmission gate 714 and two pass gates 718 of the third sum circuit 610. The transmission gate 714 is controlled by the XN signal and the X signal, and the two pass gates 718 are controlled by the CN signal with the X signal and the XN signal as inputs to generate an output. The output received from the two pass gates 718 and the transmission gate 714 is inverted using the fourth inverter 716 to obtain the output SUM signal.

The third NOR gate 720 of the first CO circuit 612 uses the XN signal generated from the first AOI circuit 1202 of the SG circuit 602, and the CI input signal to generate a CIBARX signal (e.g. the first CO circuit output signal, otherwise known as a CInorXN signal) (representing a NOR result of the CI input signal and the X signal) as the third NOR signal. The CIBARX signal, and the AnorB signal are fed to the fourth NOR gate 722 of the second CO circuit 614 to generate the CO signal.

The first AOI circuit 1202 (and other AOI circuits discussed herein) may be implemented through a variety of different functionalities. For instance, instead of explicitly implementing an inverter gate, the inverter function may be integrated within the OR gate. For instance, the OR gate may be replaced with a NOR gate. It will be appreciated that this is functionally equivalent to implementing separate OR and inverter gates. Furthermore, an AOI circuit may implement the functionality of an AND function followed by an OR function followed by an inverter function without including explicit AND, OR and inverter gates (e.g. through a combination of transistors that results in the required logical combination without including explicit sub modules for each logical sub-step).

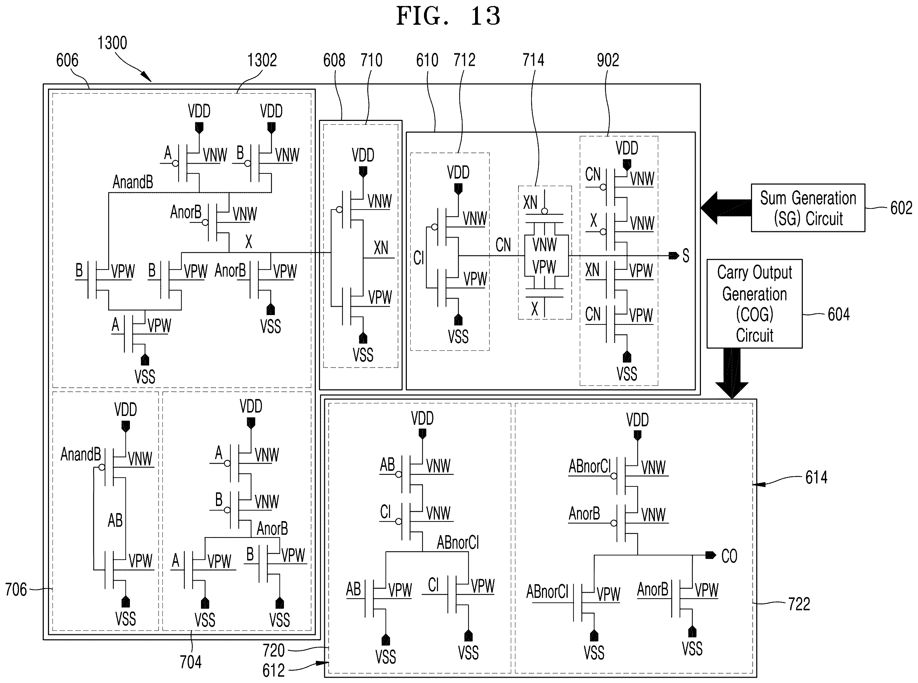

FIG. 13 depicts core circuit 1300, which is a further example of the FA circuit 600. The core circuit 1300 may include the SG circuit 602 for generating the output SUM signal, and the COG circuit 604 for generating the CO signal. The SG circuit 602 may include the second AOI circuit 1302, the first NOR gate 704, the first inverter 706 of the first sum circuit 606, the second inverter 710 of the second sum circuit 608, the third inverter 712, the transmission gate 714, and the tristate inverter 902 of the third sum circuit 610. The COG circuit 604 may include components of the first CO circuit 612, and the second CO circuit 614. In this embodiment, the first CO circuit 612 may include the third NOR gate 720, and the second CO circuit 614 may include the fourth NOR gate 722.

In the embodiment of FIG. 13, the first sum circuit 606 is configured to receive the A input signal and the B input signal and generate the X signal, a first AB signal and an AnorB signal. The second sum circuit 608 is configured to receive the X signal and generate the XN signal. The third sum circuit 610 is configured to receive the CI signal, the X signal and the XN signal and generate the SUM signal. The first CO circuit 612 is configured to receive the CI signal and the first AB signal and output a first CO circuit output signal (e.g. a ABnorCI signal) and the second CO circuit 614 is configured to receive the first CO circuit output signal and the AnorB signal and generate the CO signal.

The second AOI circuit 1302 performs an AND function of the A input signal and the B input signal, followed by an OR function with an AnorB signal, and inverting the AnorB signal to generate the X signal. The first NOR gate 704 is connected to the second AOI circuit 1302 to send the AnorB signal which is generated from the A input signal, and the B input signal. The X signal is converted to the XN signal using the second inverter 710 of the second sum circuit 608. The second AOI circuit 1302 further performs a NAND function of the A input signal and the B input signal to generate an AnandB signal, followed by an inversion of the AnandB signal to generate a second AB signal using the first inverter 706.

The third inverter 712 of the third sum circuit 610 inverts the CI input signal into a CN signal, and outputs the CN signal to the transmission gate 714 and the tristate inverter 902 of the third sum circuit 610. The transmission gate 714 is controlled by the XN signal and the X signal, and the tristate inverter 902 is controlled by the X signal and the XN signal as inputs, to obtain the output SUM signal.

The third NOR gate 720 of the first CO circuit 612 uses the second AB signal (inversion of the AnandB signal) generated from the second AOI circuit 1302 and the first inverter 706 of the SG circuit 602, and the CI input signal to generate an ABnorCI signal (e.g. a first CO circuit output signal) as the third NOR signal. The ABnorCI signal, and the AnorB signal are fed to the fourth NOR gate 722 of the second CO circuit 614 to generate the CO signal.

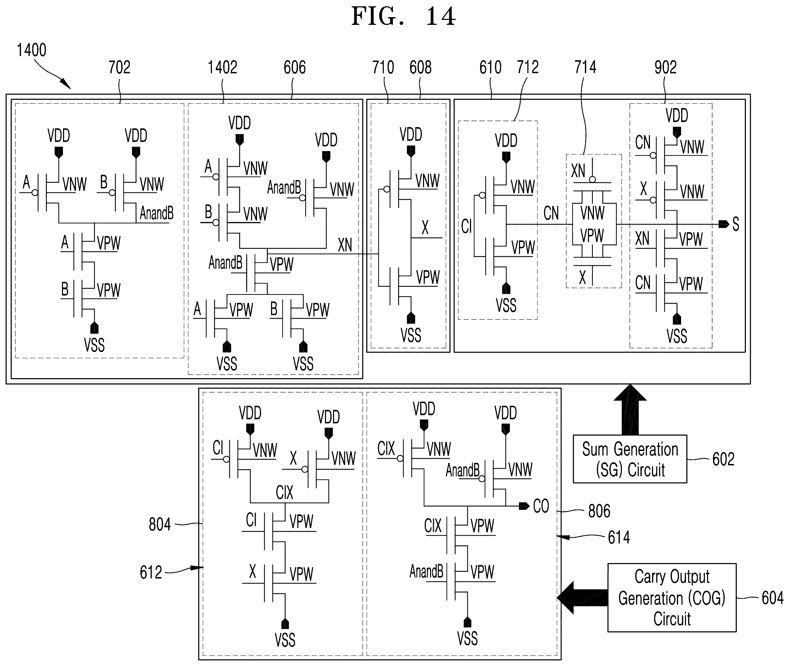

FIG. 14 depicts a core circuit 1400, which is still another example of the FA circuit 600. The core circuit 1400 may include the SG circuit 602 for generating the output SUM signal, and the COG circuit 604 for generating the CO signal. The SG circuit 602 may include the first OAI circuit 1402, and the first NAND gate 702 of the first sum circuit 606, the second inverter 710 of the second sum circuit 608, the third inverter 712, the transmission gate 714, and the tristate inverter 902 of the third sum circuit 610. The COG circuit 604 may include components of the first CO circuit 612, and the second CO circuit 614. In this embodiment herein, the first CO circuit 612 may include the third NAND gate 804, and the second CO circuit 614 may include the fourth NAND gate 806.

In the embodiment of FIG. 14, the first sum circuit 606 is configured to receive the A input signal and the B input signal and generate the X signal and an AnandB signal. The second sum circuit 608 is configured to receive the X signal and generate the XN signal. The third sum circuit 610 is configured to receive the CI signal, the X signal and the XN signal and generate the SUM signal. The first CO circuit 612 is configured to receive the CI signal and the X signal and output a first CO circuit output signal (e.g. a "CIX" signal) and the second CO circuit 614 is configured to receive the first CO circuit output signal and the AnandB signal and generate the CO signal.

The first OAI circuit 1402 may include an OR gate, an AND gate, and an inverter gate. The OAI 1402 circuit performs an OR function of the A input signal, and the B input signal, followed by an AND function with an AnandB signal, and inverting the AnandB signal to generate the XN signal. The first NAND gate 702 is connected to the first OAI circuit 1402 to send the output of the AND gate which is generated from the A input signal, and the B input signal. The XN signal is converted to the X signal using the second inverter 710 of the second sum circuit 608.

The third inverter 712 of the third sum circuit 610 inverts the CI input signal into a CN signal, and outputs the CN signal to the transmission gate 714 and the tristate inverter 902 of the third sum circuit 610. The transmission gate 714 is controlled by the XN signal and the X signal, and the tristate inverter 902 is controlled by the X signal and the XN signal as inputs, to obtain the output SUM signal.

The third NAND gate 804 of the first CO circuit 612 uses the X signal generated from the first OAI circuit 1402 of the SG circuit 602, and the CI input signal to generate a "CIX" signal (e.g. a first CO circuit output signal, otherwise known as a CInandX signal) representing a NAND result of the CI input signal and the X signal. The CIX signal, and the AnandB signal are fed to the fourth NAND gate 806 of the second CO circuit 614 to generate the CO signal.

The first OAI circuit 1302 (and other OAI circuits discussed herein) may be implemented through a variety of different functionalities. For instance, instead of explicitly implementing an inverter gate, the inverter function may be integrated within the AND gate. For instance, the AND gate may be replaced with a NAND gate. It will be appreciated that this is functionally equivalent to implementing separate AND and inverter gates. Furthermore, an OAI circuit may implement the functionality of an OR function followed by an AND function followed by an inverter function without including explicit OR, AND and inverter gates (e.g. through a combination of transistors that results in the required logical combination without including explicit sub modules for each logical sub-step).

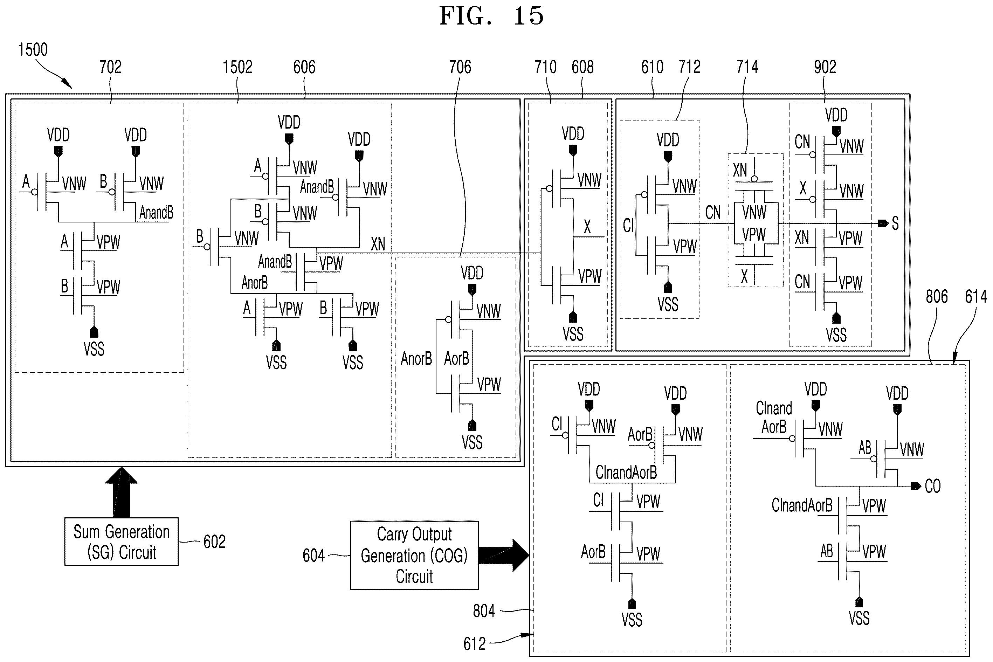

FIG. 15 depicts an alternative core circuit 1500, which is yet another example of the FA circuit 600. The core circuit 1500 may include the SG circuit 602 for generating the output SUM signal, and the COG circuit 604 for generating the CO signal. The SG circuit 602 may include the second OAI circuit 1502, the first NAND gate 702, the first inverter 706 of the first sum circuit 606, the second inverter 710 of the second sum circuit 608, the third inverter 712, the transmission gate 714, and the tristate inverter 902 of the third sum circuit 610. The COG circuit 604 may include components of the first CO circuit 612, and the second CO circuit 614. In this embodiment, the first CO circuit 612 may include the third NAND gate 804, and the second CO circuit 614 may include the fourth NAND gate 806.

In the embodiment of FIG. 15, the first sum circuit 606 is configured to receive the A input signal and the B input signal and generate the X signal and an AorB signal. The second sum circuit 608 is configured to receive the X signal and generate the XN signal. The third sum circuit 610 is configured to receive the CI signal, the X signal and the XN signal and generate the SUM signal. The first CO circuit 612 is configured to receive the CI signal and the AorB signal and output a first CO circuit output signal (e.g. a CInandAorB signal) and the second CO circuit 614 is configured to receive the first CO circuit output signal and a third AB signal, which is the AnandB signal, and generate the CO signal.

The second OAI circuit 1502 may include an OR gate, an AND gate, and an inverter gate. The second OAI circuit 1502 performs an OR function of the A input signal and the B input signal, followed by an AND function with an AnandB signal representing a NAND result of the A input signal and the B input signal, and inverting the output of the AND gate to generate the XN signal. The first NAND gate 702 is connected to the second OAI circuit 1502 to send the AnandB signal which is generated from the A input signal, and the B input signal. The XN signal is converted to the X signal using the second inverter 710 of the second sum circuit 608. The second OAI circuit 1502 further performs a NOR function of the A input signal and the B input signal to generate an AnorB signal, followed by an inversion of the AnorB signal to generate an AorB signal using the first inverter 706. That is, the second OAI circuit 1502 is configured to output the AnorB signal to the first inverter 706 which is configured to generate the AorB signal.

The third inverter 712 of the third sum circuit 610 inverts the CI input signal into a CN signal, and outputs the CN signal to the transmission gate 714 and the tristate inverter 902 of the third sum circuit 610. The transmission gate 714 is controlled by the XN signal and the X signal, and the tristate inverter 902 is controlled by the X signal and the XN signal as inputs, to obtain the output SUM signal.

The third NAND gate 804 of the first CO circuit 612 uses the AorB signal generated from the second OAI circuit 1502 of the SG circuit 602, and the CI input signal to generate a CInandAorB signal (e.g. a first CO circuit output signal). The CInandAorB signal and a third AB signal (the AnandB signal) are fed to the fourth NAND gate 806 of the second CO circuit 614 to generate the CO signal.

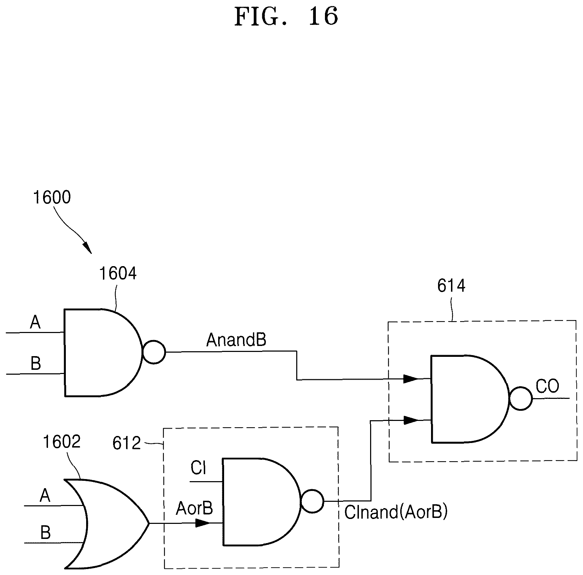

FIG. 16 schematically illustrates a logic gate circuit 1600, which is an example of the COG circuit 604. As depicted, the logic gate circuit 1600 may include the first CO circuit 612 having a NAND gate which receives an input of the CI signal and the AorB signal from an OR gate 1602, and generates a CInand(AorB) signal. The output from the first CO circuit 612 is connected to the second CO circuit 614 having a NAND gate which receives inputs of the AnandB signal from a NAND gate 1604, and the CInand(AorB) signal from the first CO circuit 612, and generates a CO signal.

In an embodiment herein, based on Boolean analysis, the Carry Out is a majority function which is given as, M = A.B + B.C + C.A, where C is a CI signal.

The FA circuit 600 can be implemented with the majority function as given below for providing slower slews:

$$M = \overline{\overline{A.B} + \overline{C.A} + \overline{B.C}}$$

Thus, the FA circuit 600 can invert the signals first and then perform the algebraic calculation on a stacked device. This improves the internal propagation delay in a cell, thereby providing high performance.

Further, the SUM output signal may be given by:

$$S = A\ XOR\ B\ XOR\ C$$

$$S = AN.BN.C + AN.B.CN + A.BN.CN + A.B.C$$

Where AN, BN and CN represent the inverse of A, B and C respectively. The SUM signal may be a sum of the A input signal, the B input signal and the CI signal, where carry-overs are ignored. The SUM output signal can be implemented in a single stage using an XOR circuit with a mix of stacked transistors and pass gates. This results in good average performance across the sum arcs. However, A1B0 and A0B1 CarryIn to CarryOut arcs may be of particular interest, as shown in Table 1. Therefore, the FA circuit 600 can be optimized in two variants: a first variant is for A1B0 and a second variant is for A0B1. The FA circuit 600 optimization with the variants is shown in Table 1.

| Inputs | | | Outputs | |
|---|---|---|---|---|
| A | B | $C_{in}$ | Sum | Carry |
| 0 | 0 | 0 | 0 | 0 |
| 0 | 0 | 1 | 1 | 0 |
| 0 | 1 | 0 | 1 | 0 |
| 0 | 1 | 1 | 0 | 1 |
| 1 | 0 | 0 | 1 | 0 |
| 1 | 0 | 1 | 0 | 1 |
| 1 | 1 | 0 | 0 | 1 |
| 1 | 1 | 1 | 1 | 1 |

**Table 1**

Embodiments of the FA circuit 600 may be highly optimized for the CarryIn to CarryOut path. This improves the performance for high transition time input signals. The FA circuit 600 may have reduced CI2CO delay as compared to existing FA circuits.

The FA circuit 600 can be utilized in mobile phones, cameras, TV, high speed standard cell library applications, high performance computing, Artificial Intelligence and Machine Learning GPUs, full custom ripple carry adders, highly slew constraint and long signal nets, arithmetic logic unit and signal multiplexing in high speed modems, and so on.

Embodiments of the FA circuit 600 may be a restructured logic circuit that provides optimal use of the transistors and limits the net and transistor input capacitance. The circuit may be implemented in fewer number of stages than existing circuits, yet may provide comparable performance at high input slews. This circuit is NAND2 followed by NAND2 hence only 2 stages and best in terms of frequency. The FA circuit 600 is a fully static design based on a method driven Boolean analysis. Thus, the circuit may be fully optimized for applicable and practical high speed circuit applications like Arcwise® and pin specific latency optimization. The FA circuit 600 performance advantage increases when high transition time signal nets driven by long metal wires are used for ADDF computing. A CI input pin and a CN/CIX/CIBARX signal may be connected to 2 MOS/ 4 MOS, hence input capacitance for a preceding stage may be significantly reduced. The number of stages in the FA circuit 600 is reduced, which may ensure that the circuit provides good performance in low fan-out loads. The FA circuit 600 may ensure full rail to rail VDD swing, with the topology optimized to provide an area benefit in layout.

Embodiments are set out in the following Clauses:

1. A Full Adder (FA) circuit, comprising:

a Sum Generation (SG) circuit configured to:

generate at least one of an XNOR ("XN") signal, and an XOR ("X") signal using at least one of a first NOR signal, an AND signal, a NAND signal, and an OR signal; and
generate an output SUM signal using the generated at least one of the XN signal, and the X signal; and

a Carry Output Generation (COG) circuit connected to the SG circuit and configured to generate a Carry Output (CO) signal using the at least one of the first NOR signal, the AND signal, the NAND signal, or the OR signal.

2. The FA circuit of Clause 1, wherein the SG circuit comprises:

a first sum circuit configured to receive a first input signal and a second input signal, and generate the at least one of the first NOR signal, the AND signal, the NAND signal, and the OR signal based on the first input signal and the second input signal;

a second sum circuit connected to the first sum circuit and configured to generate the at least one of the XN signal, and the X signal using the at least one of the first NOR signal, the AND signal, the NAND signal, and the OR signal; and

a third sum circuit connected to the second sum circuit and configured to generate the output SUM signal using a third input signal, and the at least one of the XN signal, and the X signal.

3. The FA circuit of Clause 2, wherein the COG circuit comprises:

a first Carry Output (CO) circuit connected to the first sum circuit and configured to generate a third NOR signal using the third input signal and at least one of the AND signal or the OR signal; and

a second CO circuit connected to the first CO circuit and the first sum circuit and configured to generate the CO signal using the third NOR signal and at least one of the first NOR signal or the NAND signal.

4. The FA circuit of Clause 2 or Clause 3, wherein:

the first input signal is a first single binary digit "A" input signal,

the second input signal is a second single binary digit "B" input signal,

the third input signal is a Carry-In (CI) input signal,

the first sum circuit comprises at least one of a first NOR gate, a first NAND gate, or a first inverter,

the second sum circuit comprises at least one of a second NOR gate, a second NAND gate, or a second inverter, and

the third sum circuit comprises at least one of a third inverter, a tristate inverter, a transmission gate, at least one pass gate pair, or a fourth inverter.

5. The FA circuit of in Clause 4, wherein:

the first NOR gate of the first sum circuit performs a NOR function of the A input signal and the B input signal, and generates an AorBbar signal as the first NOR signal,

the first NAND gate followed by the first inverter of the first sum circuit performs an AND function of the A input signal and the B input signal, and generates a first AB signal as the AND signal,

the second NOR gate of the second sum circuit performs a NOR function of the first AB signal and the AorBbar signal, and generates the X signal, and

the X signal is converted to the XN signal using the second inverter of the second sum circuit.

6. The FA circuit of Clause 4, wherein:

the first NAND gate of the first sum circuit performs a NAND function of the A input signal and the B input signal, and generates a ABbar signal as the NAND signal,

the first NOR gate followed by the first inverter of the first sum circuit performs an OR function of the A input signal and the B input signal, and generates an AorB signal as the OR signal,

the second NAND gate of the second sum circuit performs a NAND function of the AorB signal and the ABbar signal, and generates the XN signal, and

the XN signal is converted to the X signal using the second inverter of the second sum circuit.

7. The FA circuit of any of Clauses 4-6, wherein:

the third inverter of the third sum circuit inverts a Carry-In (CI) input signal into a "CN" signal, and outputs the CN signal to the transmission gate and two pass gates of the third sum circuit,

the transmission gate is controlled by the XN signal and the X signal, and the two pass gates are controlled by the CN signal with the X signal and the XN signal as inputs, to generate an output, and

the output received from the two pass gates and the transmission gate is inverted using the fourth inverter to obtain the output SUM signal.

8. The FA circuit of any of Clauses 4-6, wherein:

the third inverter of the third sum circuit inverts a Carry-In (CI) input signal into a "CN" signal,
the transmission gate and the tristate inverter are fed with the CN signal and controlled by the X signal and the XN signal of the second sum circuit, and
outputs of the transmission gate and the tristate inverter are connected to generate the output SUM signal.

9. The FA circuit of any of Clauses 4-6, wherein:

the third inverter of the third sum circuit inverts a carry-in (CI) input signal into the CN signal,
the transmission gate and the tristate inverter are fed with the XN signal of the second sum circuit, and controlled by the CI signal and the CN signal, and
outputs of the transmission gate and the tristate inverter are connected to generate the output SUM signal.

10. The FA circuit of any of Clauses 4-6, wherein:

the third inverter of the third sum circuit inverts a Carry-In (CI) input signal into a "CN" signal,
the transmission gate and the tristate inverter are fed with the XN signal of the second sum circuit, and
the transmission gate is controlled by the CI input signal and the CN signal, and the tristate inverter is controlled by the CI input signal and the CN signal, followed by the fourth inverter to generate the output SUM signal.

11. The FA circuit of any of Clauses 1-3, wherein:

the SG circuit comprises an AND-OR-Inverter (AOI) circuit,
the AOI circuit comprises an AND gate, an OR gate, and an inverter gate to perform an AND function of an A input signal and a B input signal, followed by an OR function with an AnorB signal representing a NOR result of the A input signal and the B input signal, and inverting the AnorB signal to generate the X signal,
the X signal is converted to the XN signal using the second inverter of the second sum circuit, wherein the AOI circuit is connected to the first NOR gate of the first sum circuit for receiving the AnorB signal, and
the AOI circuit further performs a NAND function of the A input signal, and the B input signal to generate an AnandB signal, followed by an inversion of the AnandB signal to generate a second AB signal.

12. The FA circuit of any of Clauses 1-3, wherein:

the SG circuit comprises an OR-AND-Inverter (OAI) circuit including an OR gate, an AND gate, and an inverter gate,
the OAI circuit performs an OR function of an A input signal and a B input signal, followed by an AND function with an AnandB signal representing a NAND result of the A input signal and the B input signal, and inverting the AnandB signal to generate the XN signal,
the XN signal is converted to the X signal using the second inverter of the second sum circuit,
the OAI circuit is connected to the first NAND gate of the first sum circuit for receiving the AnandB signal, and

wherein the OAI circuit further performs a NOR function of the A input signal and the B input signal to generate an AnorB signal, followed by an inversion of the AnorB signal to generate an AorB signal.

13. The FA circuit of Clause 11 or Clause 12, wherein:

the third inverter of the third sum circuit inverts a Carry-In (CI) input signal into a "CN" signal, and outputs the CN signal to the transmission gate and the tristate inverter of the third sum circuit, and
the transmission gate is controlled by the XN signal and the X signal, and the tristate inverter is controlled by the X signal and the XN signal as inputs, to obtain the output SUM signal.

14. The FA circuit of Clause 3, wherein:

the first CO circuit comprises at least one of a third NOR gate or a third NAND gate; and
the second CO circuit comprises at least one of a fourth NOR gate or a fourth NAND gate.

15. The FA circuit of Clause 14, wherein:

the third NOR gate of the first CO circuit uses a first AB signal, which represents an AND result of an A input signal and a B input signal, from the first sum circuit, and the CI input signal to generate a CnorAB signal as the third NOR signal, and

the CnorAB signal and an AorBbar signal representing a NOR result of the A input signal and the B input signal from the first sum circuit are fed to the fourth NOR gate of the second CO circuit to generate the CO signal.

The foregoing description of the specific embodiments will so fully reveal the general nature of the embodiments herein that others can, by applying current knowledge, readily modify and/or adapt for various applications such specific embodiments without departing from the generic concept, and, therefore, such adaptations and modifications should and are intended to be comprehended within the meaning and range of equivalents of the disclosed embodiments. It is to be understood that the phraseology or terminology employed herein is for the purpose of description and not of limitation. Therefore, while the embodiments herein have been described in terms of embodiments and examples, those skilled in the art will recognize that the embodiments and examples disclosed herein can be practiced with modification within the scope of the embodiments as described herein.

**Claims**

1. A Full Adder, FA, circuit, comprising:

   a Sum Generation, SG, circuit (602) configured to:

   generate at least one of an XNOR signal, and an XOR signal using at least one of a first NOR signal, an AND signal, a NAND signal, and an OR signal; and
   generate an output SUM signal using the generated at least one of the XNOR signal,

   and the XOR signal; and
   a Carry Output Generation, COG, circuit (604) connected to the SG circuit and configured to generate a Carry Output, CO, signal using the at least one of the first NOR signal, the AND signal, the NAND signal, or the OR signal.

2. The FA circuit of claim 1, wherein the SG circuit (602) comprises:

   a first sum circuit (606) configured to receive a first input signal and a second input signal, and generate the at least one of the first NOR signal, the AND signal, the NAND signal, and the OR signal based on the first input signal and the second input signal;
   a second sum circuit (608) connected to the first sum circuit (606) and configured to generate the at least one of the XNOR signal (608), and the XOR signal using the at least one of the first NOR signal, the AND signal, the NAND signal, and the OR signal; and
   a third sum circuit (610) connected to the second sum circuit (608) and configured to generate the output SUM signal using a third input signal, and the at least one of the XNOR signal, and the XOR signal.

3. The FA circuit of claim 2, wherein the first sum circuit (606) is configured to generate at least one of the AND signal or the OR signal, and is configured to generate at least one of the first NOR signal or the NAND signal, and wherein the COG circuit (604) comprises:

   a first CO circuit (612) connected to the first sum circuit (606) and configured to generate a third NOR signal using the third input signal and the at least one of the AND signal or the OR signal; and
   a second CO circuit (614) connected to the first CO circuit (612) and the first sum circuit (606) and configured to generate the CO signal using the third NOR signal and the at least one of the first NOR signal or the NAND signal.

4. The FA circuit of claim 2 or claim 3, wherein:

   the first input signal is a first single binary digit, A, input signal,
   the second input signal is a second single binary digit, B, input signal,
   the third input signal is a Carry-In, CI, input signal,
   the first sum circuit (606) comprises at least one of a first NOR gate, a first NAND gate, or a first inverter,
   the second sum circuit (608) comprises at least one of a second NOR gate, a second NAND gate, or a second inverter, and

the third sum circuit (610) comprises at least one of a third inverter, a tristate inverter, a transmission gate, at least one pass gate pair, or a fourth inverter.

5. The FA circuit of in claim 4, wherein:

the first sum circuit (606) comprises the first NOR gate, which is configured to perform a NOR function of the A input signal and the B input signal, and generate an AorBbar signal as the first NOR signal,
the first sum circuit (606) comprises the first NAND gate followed by the first inverter, which are configured to perform an AND function of the A input signal and the B input signal, and generate a first AB signal as the AND signal,
the second sum circuit (608) comprises the second NOR gate, which is configured to perform a NOR function of the first AB signal and the AorBbar signal, and generate the XOR signal, and
the second sum circuit (608) comprises the second inverter, which is configured to convert the XOR signal to the XNOR signal.

6. The FA circuit of claim 4, wherein:

the first sum circuit (606) comprises the first NAND gate, which is configured to perform a NAND function of the A input signal and the B input signal, and generate an ABbar signal as the NAND signal,
the first sum circuit (606) comprises the first NOR gate followed by the first inverter, which are configured to perform an OR function of the A input signal and the B input signal, and generate an AorB signal as the OR signal,
the second sum circuit (608) comprises the second NAND gate, which is configured to perform a NAND function of the AorB signal and the ABbar signal, and generate the XNOR signal, and
the second sum circuit (608) comprises the second inverter, which is configured to convert the XNOR signal to the XOR signal.

7. The FA circuit of any of claims 4-6, wherein:

the third sum circuit (610) comprises the third inverter, the transmission gate, two pass gates and the fourth inverter, wherein the third inverter of the third sum circuit (610) is configured to invert the CI input signal into a CN signal, and output the CN signal to the transmission gate and the two pass gates of the third sum circuit (610),
the transmission gate is configured to be controlled by the XNOR signal and the XOR signal, and the two pass gates are configured to be controlled by the CN signal with the XOR signal and the XNOR signal as inputs, to generate an output, and
the fourth inverter is configured to invert the output received from the two pass gates and the transmission gate to obtain the output SUM signal.

8. The FA circuit of any of claims 4-6, wherein:

the third sum circuit (610) comprises the third inverter, the transmission gate, and the tristate inverter,
the third inverter of the third sum circuit (610) is configured to invert the CI input signal into a CN signal,
the transmission gate and the tristate inverter are configured to be fed with the CN signal and controlled by the XOR signal and the XNOR signal of the second sum circuit (608), and
outputs of the transmission gate and the tristate inverter are connected to generate the output SUM signal.

9. The FA circuit of any of claims 4-6, wherein:

the third sum circuit (610) comprises the third inverter, the transmission gate, and the tristate inverter,
the third inverter of the third sum circuit (610) is configured to invert the CI input signal into the CN signal,
the transmission gate and the tristate inverter are configured to be fed with the XNOR signal of the second sum circuit (608), and controlled by the CI signal and the CN signal, and
outputs of the transmission gate and the tristate inverter are connected to generate the output SUM signal.

10. The FA circuit of any of claims 4-6, wherein:

the third sum circuit (610) comprises the third inverter, the transmission gate, the tristate inverter, and the fourth inverter,
the third inverter of the third sum circuit (610) is configured to invert the CI input signal into a CN signal,

the transmission gate and the tristate inverter are configured to be fed with the XNOR signal of the second sum circuit (608), and

the transmission gate is configured to be controlled by the CI input signal and the CN signal, and the tristate inverter is configured to be controlled by the CI input signal and the CN signal, followed by the fourth inverter to generate the output SUM signal.

11. The FA circuit of any of claims 1-3, wherein:

the SG circuit (602) comprises an AND-OR-Inverter, AOI, circuit,

the AOI circuit comprises an AND gate, an OR gate, and an inverter gate, the AOI circuit is configured to perform an AND function of an A input signal and a B input signal, followed by an OR function with an AnorB signal representing a NOR result of the A input signal and the B input signal, and inverting the AnorB signal to generate the XOR signal,

the second sum circuit (608) comprises a second inverter configured to convert the XOR signal to the XNOR signal, wherein the AOI circuit is connected to a first NOR gate of the first sum circuit (606) for receiving the AnorB signal, and

the AOI circuit is further configured to perform a NAND function of the A input signal, and the B input signal to generate an AnandB signal, followed by an inversion of the AnandB signal to generate a second AB signal.

12. The FA circuit of any of claims 1-3, wherein:

the SG circuit (602) comprises an OR-AND-Inverter, OAI, circuit including an OR gate, an AND gate, and an inverter gate,

the OAI circuit is configured to perform an OR function of an A input signal and a B input signal, followed by an AND function with an AnandB signal representing a NAND result of the A input signal and the B input signal, and inverting the AnandB signal to generate the XNOR signal,

the second sum circuit (608) comprises a second inverter that is configured to convert the XNOR signal to the XOR signal,

the OAI circuit is connected to a first NAND gate of the first sum circuit (606) for receiving the AnandB signal, and

wherein the OAI circuit is further configured to perform a NOR function of the A input signal and the B input signal to generate an AnorB signal, followed by an inversion of the AnorB signal to generate an AorB signal.

13. The FA circuit of claim 11 or claim 12, wherein:

the third sum circuit (610) comprises a third inverter, a transmission gate and a tristate inverter,

the third inverter of the third sum circuit (610) is configured to invert a Carry-In, CI, input signal into a CN signal, and output the CN signal to the transmission gate and the tristate inverter of the third sum circuit (610), and

the transmission gate is configured to be controlled by the XNOR signal and the XOR signal, and the tristate inverter is configured to be controlled by the XOR signal and the XNOR signal as inputs, to obtain the output SUM signal.

14. The FA circuit of claim 3, wherein:

the first CO circuit (612) comprises at least one of a third NOR gate or a third NAND gate; and

the second CO circuit (614) comprises at least one of a fourth NOR gate or a fourth NAND gate.

15. The FA circuit of claim 14, wherein:

the third NOR gate of the first CO circuit (612) is configured to use a first AB signal, which represents an AND result of an A input signal and a B input signal, from the first sum circuit (606), and the CI input signal to generate a CnorAB signal as the third NOR signal, and

the CnorAB signal and an AorBbar signal representing a NOR result of the A input signal and the B input signal from the first sum circuit (606) are fed to the fourth NOR gate of the second CO circuit (614) to generate the CO signal.

FIG. 1

FIG. 2

# FIG. 3

# FIG. 4

# FIG. 5A

# FIG. 5B

FIG. 6

FIG. 7

# FIG. 8

EP 4 760 482 A1

FIG. 9

# FIG. 10

EP 4 760 482 A1

FIG. 11

# FIG. 12

EP 4 760 482 A1

FIG. 13

# FIG. 14

# FIG. 15

EP 4 760 482 A1

FIG. 16

1600

1604

A
B

AnandB

614

CO

1602

612

CI

AorB

CInand(AorB)

A
B

<table>
<tr><td>Europäisches<br>Patentamt<br>European<br>Patent Office<br>Office européen<br>des brevets</td><td align="center">**EUROPEAN SEARCH REPORT**</td><td>**Application Number**<br><br>**EP 25 22 1601**</td></tr>
</table>

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/311082 A1 (ZOND SAURABH SHANKAR [IN] ET AL) 19 September 2024 (2024-09-19) * figures 2-5 * * paragraph [0022] - paragraph [0062] * ----- | 1-15 | INV. G06F7/501 H03K19/0948 |
| X | US 2021/124558 A1 (ELKIN ILYAS [US] ET AL) 29 April 2021 (2021-04-29) * figure 5 * * paragraph [0036] - paragraph [0044] * ----- | 1 | |

**TECHNICAL FIELDS SEARCHED (IPC)**

G06F
H03K

The present search report has been drawn up for all claims

| Place of search | Date of completion of the search | Examiner |
|---|---|---|
| Munich | 30 April 2026 | Winkelbauer, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.............................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 22 1601

This annex lists the patent family members relating to the patent documents cited in the above-mentioned European search report.
The members are as contained in the European Patent Office EDP file on
The European Patent Office is in no way liable for these particulars which are merely given for the purpose of information.

30-04-2026

| Patent document cited in search report | | Publication date | Patent family member(s) | | Publication date |
|---|---|---|---|---|---|
| US 2024311082 | A1 | 19-09-2024 | CN | 118672546 A | 20-09-2024 |
| | | | EP | 4432071 A1 | 18-09-2024 |
| | | | EP | 4432072 A1 | 18-09-2024 |
| | | | TW | 202439783 A | 01-10-2024 |
| | | | US | 2024311082 A1 | 19-09-2024 |
| US 2021124558 | A1 | 29-04-2021 | NONE | | |

EPO FORM P0459